# EUROPEAN PATENT SPECIFICATION

(11) **EP 2 249 564 B1**
(45) Date of publication and mention of the grant of the patent: **31.05.2017**
(21) Application number: 10161341.2
(22) Date of filing: 28.04.2010
(51) Int. Cl.: H03H 7/52, H04N 7/10

(54) **Electrical isolating device**
Elektrische Isoliervorrichtung
Dispositif d'isolation électrique

(30) Priority: 08.05.2009 GB 0907931; 19.05.2009 GB 0908566
(43) Date of publication of application: 10.11.2010
(73) Proprietor: Technetix Group Limited, Burgess Hill West Sussex RH15 9TZ (GB)
(72) Inventor: Rijssemus, Martien, 6866 EM, Heelsum (NL)
(74) Representative: Forsyth, Helen Jane

(56) References cited:
- DE-A1- 4 238 328
- "Filters and Interference" In: "The 1987 ARRL Handbook for the Radio Amateur" October 1986 (1986-10), American Radio Relay League , Newington, CT, USA , XP002596780 ISBN: 0-87259-064-X , page 40-9 * pages 40-9, left-hand column, line 38 - column c, line 15 * * figures 13, 14 *

## Description

### Field of the Invention

This invention relates to an improved electrical isolating device and in particular an improved galvanic isolator for use in broadband networks and cable television networks.

### Background to the Invention

Electrical isolating devices such as galvanic isolators are used in cable television networks for many reasons, including preventing hum modulation, preventing galvanic corrosion and as a safety device. The isolators generally use capacitors to block DC and AC 50Hz or 60Hz and for safety reasons the leakage current needs not to exceed certain limits. Also the isolator needs to have a very high screening efficiency to ensure that no radio frequency voltage leaks from the isolator and interferes with other electrical signals. To gain a good screening efficiency at low frequencies, the value of the capacitors should be very large but with such large capacitors, leakage currents become a problem.

It is an aim of the present invention to provide an improved isolating device with good screening efficiency, particularly at low frequencies.

### Summary of the Invention

In accordance with one aspect of the present invention, there is provided an electrical isolating device for use in a broadband or cable television (CATV) network comprising an input connected by an electrical path to an output, with one or more capacitors connected from the electrical path to ground for electrical screening, wherein at least one resonant device is connected between the electrical path and ground. The resonant device has a very low impedance when at resonance and this allows the electrical screening efficiency to be improved without detrimental increases to the leakage current.

The resonant device preferably is connected in series between the electrical path and ground, so forming a series-resonant circuit.

The resonant device preferably further comprises a capacitor and inductor in series with each other. Preferably the capacitor has a high value, typically in the range 330pF - 4,7nF, with the inductors having a value in the range 47nH to 680nH.

Desirably the resonant device has a resonance frequency close to or within the frequency range for which electrical screening is required and the values of components, such as the capacitor and inductor, within the resonant device are selected accordingly.

The present invention is of particular use for low frequency screening in the range 1MHz to 15MHz. However, the characteristics of the resonant device may be selected to provide improved electrical screening at any frequency range where low impedance is required.

The isolating device may be provided with one or more resonant devices and the resonant devices may have the same of different characteristics depending on the frequencies at which electrical screening is required. For example, first, second and third resonant devices may be provided with different resonance frequencies so that screening efficiency is improved over a broad frequency range. Thus if required a plurality of resonant devices, each with different resonance characteristics may be selected.

In accordance with another aspect to the present invention, there is provided a broadband or cable television network incorporating one or more electrical isolating devices as aforesaid.

The invention will now be described, by way of example, and with reference to the accompanying drawings in which:
Figure 1 shows a circuit diagram of a prior art isolator;
Figure 2 shows a plan view of the circuit components in a prior art isolator;
Figure 3 shows a circuit diagram of an isolator in accordance with the present invention; and
Figures 4(a) and(b) depict graphs of electrical screening against frequency for a prior art isolator and an isolator in accordance with the invention.

### Description

Galvanic isolators are used in CATV networks for many reasons, with the main reasons being : a) the prevention of hum modulation, b) the prevention of galvanic corrosion and c) as a safety device.

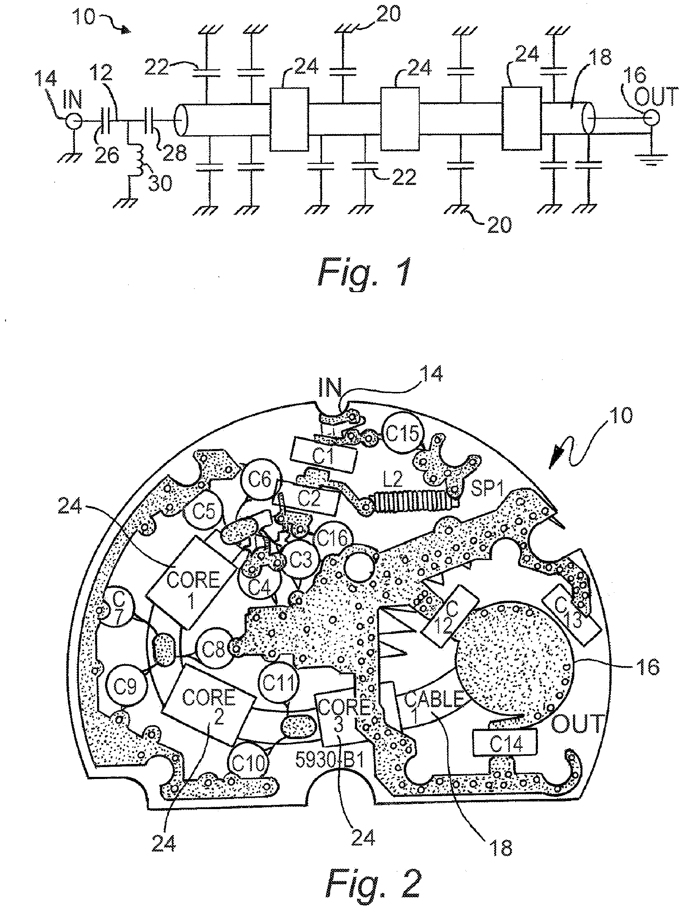

The isolators 10 are typically made using capacitors as the main DC and AC 50/60 Hz isolating element. A typical prior art circuit is shown in Figure 1 with Figure 2 showing the layout of a typical device 10 for reference and explanatory reasons. Many different models exist but the technology is the same. In Figure 1, an electrical path 12 runs between an input 14 and output 16 of the galvanic isolator 10, with the main part of the electrical path being provided by coaxial cable 18 connected to ground 20 at a number of points by capacitors 22. Ferrite cores 24 are placed on the outside of the coaxial cable 18 and these cores in combination with the capacitors 22 ensure that only very little RF (radio frequency) voltage can leak from the isolator 10. The capacitors 22 are typically of different values to achieve a wide band characteristic. Capacitors 26, 28 and inductor 30 form a highpass filter to prevent migration of lightning-induced pulses.

The capacitors 22 are high voltage types (typical > 1kV). The value of the capacitors 22 is large enough so RF voltages will not be affected by the capacitors 22 but small enough so DC and AC 50Hz or 60 Hz will be blocked both from IN 14 to OUT 16 as well as from OUT-ground to IN-ground or in every other combination.

As the isolator 10 is also used as a safety device, the leakage current should not exceed a certain limit when a 230 V 50 (or 60) Hz AC voltage is applied across the isolator 10. The safety limit of the leakage current is set to 8mA but for some CATV networks 2mA is the maximum leakage current where up to four isolators are placed in parallel.

Such an isolator 10 should also have a very high screening efficiency. This means that no RF voltage should leak from the isolator causing unwanted radiation that might interfere with other services and no RF voltage should leak into the isolator from other services that might cause interference with the CATV services.

In order to get a good screening efficiency at low frequencies (typically below 15 MHz), the value of the capacitors 22 placed in the ground circuit should be very large as the impedance at this point should be extremely low to prevent leakage. However at 230 V AC such high value capacitors will allow for leakage currents larger than safety would dictate as a maximum, i.e. greater than 8 or 2 mA.An arrangement similar to the one described above is known from document DE4238328 A1.

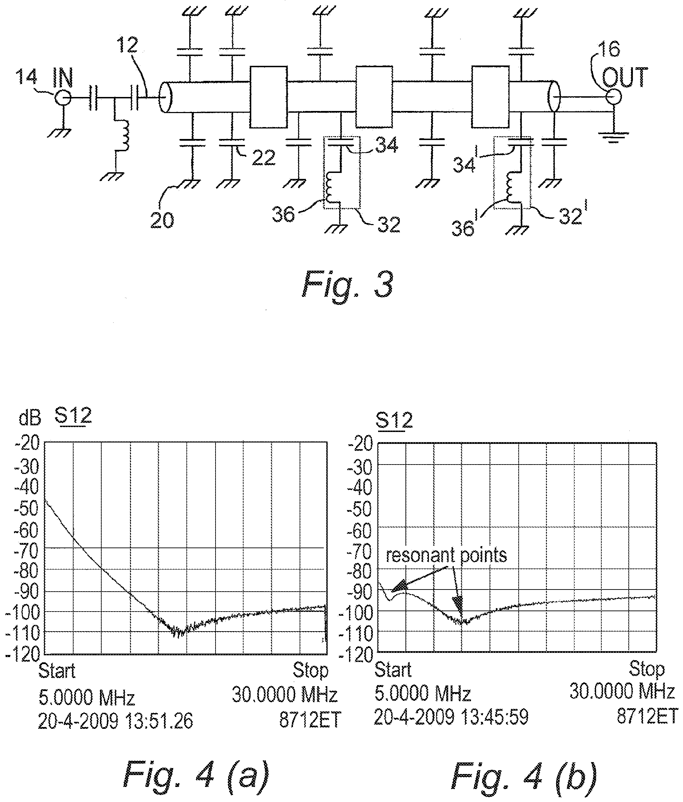

An isolator circuit in accordance with the present invention is shown in Figure 3 with one of the capacitors 22 replaced by resonant circuit 32. As many capacitors 22 can be replaced by resonant circuits as required, and in Figure 3, two resonant circuits 32, 32' are shown. Resonant circuit 32 comprises capacitor 34 and inductor 36 which together form a series resonant circuit with a very low impedance to ground, or earth, at low frequencies between 1MHz to 15MHz.

Each series resonant circuit 32, 32' has a very low impedance at and around its resonance frequency, with the frequency of the resonance point chosen so that the screening efficiency is improved at low frequencies between 1MHz to 15MHz or for whatever frequency needed. The resonance frequencies for each resonant circuit 32, 32' can be the same but they can be selected to be different depending on the electrical configuration of a particular isolator. The exact place of the resonant circuit 32, 32' within the isolator 10 and the exact value of the components within the resonant circuit, such as capacitor 34, 34' and inductor 36, 36', can differ depending on the isolator model.

By adding one or more series-resonant circuits 32 which use small high-voltage capacitors and simple inductors, the impedance in the ground circuit is lowered by using the resonance properties of the resonant circuit without needing to add additional capacitors or to increase the value of the capacitors.

Figure 4 shows graphs comparing low frequency screening efficiency for a prior art isolator, Figure 4(a), and for an isolator in accordance with the present invention, Figure 4(b). The screening for the prior art isolator is very poor in the frequency range around 5MHz to around 15MHz, with a range of around -50dB to around - 100dB. For the present invention, over the same frequency range of 5 to 15MHz, the range is from around -90dB to around -100dB. The resonance points of the circuits 32, 32' can be clearly seen in Figure 4(b). By appropriate selection of the values of the components within the resonant circuit, the circuits can be designed to resonate near a desired frequency range and so the invention is particularly useful where low impedance is required, whatever the frequency range at which that impedance is required, although it does have particular advantages for improvements in screening efficiency for broadband and CATV networks.

## Claims

1. An electrical isolating device for use in a broadband or cable television (CATV) network comprising an input connected by an electrical path to an output, with one or more capacitors connected from the electrical path to ground for electrical screening, **characterised in that** at least one resonant device is connected between the electrical path and ground.

2. An electrical isolating device according to claim 1, wherein the resonant device is connected in series between the electrical path and ground.

3. An electrical isolating device according to claim 1 or claim 2, wherein the resonant device comprises a capacitor and inductor in series with each other.

4. An electrical isolating device according to any of the preceding claims, wherein the resonant device has a resonance frequency close to or within a frequency range for which electrical screening is required.

5. An electrical isolating device according to any of the preceding claims provided with two or more resonant devices.

6. An electrical isolating device according to any of claims 1 to 5, provided with a plurality of resonant devices, each with different resonance characteristics.

7. A broadband or cable television network incorporating one or more electrical isolating devices in accordance with claims 1 to 6.

## Patentansprüche

1. Elektrische Isoliervorrichtung zur Verwendung in einem Breitband- oder Kabelfernseh (CATV)-Netzwerk, die einen Eingang umfasst, der durch einen elektrischen Pfad mit einem Ausgang verbunden ist, wobei ein oder mehrere Kondensatoren zur elektrischen Abschirmung vom elektrischen Pfad mit Masse verbunden ist bzw. sind, **dadurch gekennzeichnet, dass** mindestens eine Resonanzvorrichtung zwischen dem elektrischen Pfad und der Masse geschaltet ist.

2. Elektrische Isoliervorrichtung nach Anspruch 1, wobei die Resonanzvorrichtung zwischen dem elektrischen Pfad und der Masse in Reihe geschaltet ist.

3. Elektrische Isoliervorrichtung nach Anspruch 1 oder Anspruch 2, wobei die Resonanzvorrichtung einen Kondensator und eine Induktivität, die miteinander in Reihe geschaltet sind, umfasst.

4. Elektrische Isoliervorrichtung nach einem der vorangegangenen Ansprüche, wobei die Resonanzvorrichtung eine Resonanzfrequenz nahe oder innerhalb eines Frequenzbereichs, für den die elektrische Abschirmung benötigt wird, aufweist.

5. Elektrische Isoliervorrichtung nach einem der vorangegangenen Ansprüche, die mit zwei oder mehr Resonanzvorrichtungen ausgestattet ist.

6. Elektrische Isoliervorrichtung nach einem der Ansprüche 1 bis 5, die mit mehreren Resonanzvorrichtungen, jede mit unterschiedlichen Resonanzeigenschaften, ausgestattet ist.

7. Breitband- oder Kabelfernsehnetzwerk, das eine oder mehrere elektrische Isoliervorrichtungen gemäß den Ansprüchen 1 bis 6 beinhaltet.

## Revendications

1. Dispositif d'isolation électrique destiné à être utilisé dans un réseau à large bande ou de télévision par câble (CATV) comprenant une entrée reliée par un trajet électrique à une sortie, un ou plusieurs condensateurs étant montés du trajet électrique à la masse à des fins de blindage électrique, **caractérisé en ce qu'**au moins un dispositif résonant est monté entre le trajet électrique et la masse.

2. Dispositif d'isolation électrique selon la revendication 1, dans lequel le dispositif résonant est monté en série entre le trajet électrique et la masse.

3. Dispositif d'isolation électrique selon la revendication 1 ou la revendication 2, dans lequel le dispositif résonant comprend un condensateur et une inductance en série l'un avec l'autre.

4. Dispositif d'isolation électrique selon l'une quelconque des revendications précédentes, dans lequel le dispositif résonant possède une fréquence de résonance qui est proche d'une plage de fréquences pour laquelle un blindage électrique s'avère nécessaire, ou qui s'inscrit dans cette plage.

5. Dispositif d'isolation électrique selon l'une quelconque des revendications précédentes, pourvu d'au moins deux dispositifs résonants.

6. Dispositif d'isolation électrique selon l'une quelconque des revendications 1 à 5, pourvu d'une pluralité de dispositifs résonants, possédant chacun des caractéristiques de résonance différentes.

7. Réseau à large bande ou de télévision par câble incorporant une ou plusieurs dispositifs d'isolation électrique selon les revendications 1 à 6.
